# EUROPÄISCHE PATENTSCHRIFT

(11) **EP 2 324 570 B1**
(45) Veröffentlichungstag und Bekanntmachung des Hinweises auf die Patenterteilung: **26.09.2018**
(21) Anmeldenummer: 09777569.6
(22) Anmeldetag: 31.07.2009
(51) Int. Cl.: H03K 17/955, H03K 17/96

(54) **VORRICHTUNG ZUR KAPAZITIVEN MESSUNG VON ÄNDERUNGEN**
APPARATUS FOR CAPACITIVELY MEASURING CHANGES
DISPOSITIF DE MESURE CAPACITIVE DE VARIATIONS

(30) Priorität: 31.07.2008 DE 102008035627
(43) Veröffentlichungstag der Anmeldung: 25.05.2011
(73) Patentinhaber: Reime, Gerd, 77815 Bühl (DE)
(72) Erfinder: Reime, Gerd, 77815 Bühl (DE)
(74) Vertreter: Reinhardt, Harry
(86) Internationale Anmeldenummer: PCT/EP2009/005550
(87) Internationale Veröffentlichungsnummer: WO 2010/012480

(56) Entgegenhaltungen:
- EP-A1- 2 245 739
- WO-A1-2006/025003
- DE-A1- 2 739 786
- DE-A1- 3 221 223
- GB-A- 2 394 775

## Beschreibung

### Bezug zu verwandten Anmeldungen

Die vorliegende Anmeldung beansprucht die Priorität der deutschen Patentanmeldung 10 2008 035 627.1, hinterlegt am 31. Juli 2008.

### Beschreibung

Die Erfindung betrifft eine Vorrichtung zur kapazitiven Messung von Änderungen in einem sensoraktiven Bereich eines Sensors unter Erzeugung eines elektrischen Feldes nach dem Oberbegriff des Anspruches 1.

### Stand der Technik

Aus der dem Oberbegriff des Anspruches 1 zu Grunde liegenden DE 40 06 119 C2 ist ein kapazitives Wegaufnehmersystem bekannt. Das System besteht aus einem Sensor beziehungsweise Oszillator, einer Sende- und Empfangskapazität, einem Demodulator und einem Schaltverstärker. Der Oszillator weist einen von außen beeinflussbaren Kondensator auf. Diesem Kondensator sind eine aktive Elektrode, eine Masseelektrode und eine zwischen diesen beiden Elektroden angeordnete Abschirmelektrode zugeordnet. Die aktive Elektrode und die Abschirmelektrode weisen das gleiche elektrische Potential auf, da die aktive Elektrode mittels einer Treiberstufe niederohmig auf die Abschirmelektrode getrieben wird. aktive Elektrode und Abschirmelektrode sind leitungsverbunden und werden vom selben Ausgang der Steuereinheit angesteuert.

Die DE 32 21 223 A1 offenbart einen kapazitiven Näherungsinitiator. Dieser besteht aus einem vollisolierten, rohrförmigen Gehäuse, an dessen Stirnseite eine Sensorelektrode angeordnet ist. Eine Schutzelektrode und eine Schirmelektrode sind der Sensorelektrode zugeordnet. Schirm- und Schutzelektrode zeichnet ihre zylindrische Ringform aus. Schutz- und Schirmelektrode sind im Inneren des Gehäuses koaxial zueinander angeordnet, wobei sich die Schutzelektrode in einem geringen Abstand zur stirnseitig angeordneten Sensorelektrode befindet. Die Schirmelektrode schließt in einem geringen Abstand an die Schutzelektrode an. Die Schutzelektrode wird als ,active guard' betrieben und ist über einen Impedanzwandler 42 mit der Sensorelektrode 13 verbunden, so dass an der Schutzelektrode dauernd das gleiche Signal wie an der Sensorelektrode anliegt.

Aus der CH 661 391 A5 ist eine Vorrichtung für eine Schaltungsanordnung zum berührungslosen Schalten von elektrischen Einrichtungen bekannt. Ein Impulsgenerator gibt dort Impulse an eine ein elektrisches Feld aussendende Elektrode über einen Signalausgang einer Treiberschaltung ab. Die Treiber- und Auswerteschaltung ist an ihrem Signaleingang mit einer weiteren Elektrode verbunden, die zugleich auf einem Bezugspotenzial liegt. Beide Elektroden werden von einer gemeinsamen Elektrode als Kondensator übergriffen, die Änderungen im Umfeld wahrnimmt und durch die Sendeelektrode kapazitiv mitgeführt wird. Kommt es bei einer derartigen Anordnung jedoch zu einer Benetzung von einer Elektrode gegen ein Bezugspotenzial, z.B. ein umgebendes Gehäuse, wird das elektrische Feld kapazitiv kurzgeschlossen und eine Erfassung von Änderungen im Umfeld ist nicht mehr möglich.

Auch die DE 697 19 321 T2 zeigt einen Verschiebungsstromsensor, bei dem ein elektrisches Feld erzeugt und von Empfangselektroden empfangen wird. Es bleibt offen, wie die Ankopplung an die Treiber/Auswerteeinheit erfolgt.

Die DE 2 239 359 A zeigt einen kapazitiven Regensensor, bei dem die Sendeelektrode gegenüber der Empfangselektrode mit einer Masseelektrode abgeschirmt ist. Damit ist die Erfassung einer Änderung in Folge der Annäherung eines Objekts leicht durch sonstige Umgebungseinflüsse beeinflusst. Das Vorliegen von Feuchtigkeit führt zu einer Amplitudenänderung.

Die US 7,019,540 B2 zeigt ein elektrostatisches Mikrofon, in dem ein Spannungsteiler vorgesehen ist. Damit liegen unterschiedliche Signal auf verschiedenen Strecken des aktiven Schwingkreises an. Wie die Ankopplung an die Treiber/Auswerteeinheit erfolgt, bleibt offen.

Die WO 2006/025003 A1 offenbart einen Annäherungssensor mit einer Sendeelektrode und einer Empfängerelektrode sowie Mitteln zum Erzeugen eines elektrischen Felds von der Sendeelektrode zur Empfängerelektrode, wobei eine Detektion eines Objekts in der Nähe des Sensors durch eine Reduktion einer Sensorausgansspannung angezeigt wird. Der Sensor weist außerdem eine elektrisch betriebene Schutzelektrode auf, die zwischen der Sendeelektrode und der Empfängerelektrode angeordnet ist.

Aus der GB 2 394 775 A ist ein kapazitiver Sensor mit einer Sendeelektrode, einer Empfängerelektrode und einem beweglichen elektrisch leitfähigen Element bekannt. Der Sensor ist so konfiguriert, dass das elektrisch leitfähige Element an eine erste Position relativ zu den Elektroden verlagerbar ist, an der die Sendeelektrode kapazitiv mit der Empfängerelektrode gekoppelt ist, und das elektrisch leitfähige Element an eine zweite Position relativ zu den Elektroden verlagerbar ist, an der die kapazitive Kopplung reduziert ist.

### Aufgabe der Erfindung

Ausgehend von diesem Stand der Technik liegt der vorliegenden Erfindung die Aufgabe zugrunde, einen kapazitiven Sensor zu schaffen, mit dem eine verlässliche Erfassung von Änderungen im Sensorumfeld erreicht werden kann und der auch bei einem Belag oder einer Benetzung hin zu einem Bezugspotenzial unempfindlich ist.

Diese Aufgabe wird durch eine Vorrichtung mit den Merkmalen des Anspruches 1 gelöst. Erfindungsgemäß sind im Wesentlichen wenigstens eine Sendeelektrode und wenigstens eine weitere Elektrode vorgesehen. Die Sendeelektrode erzeugt das elektrische Feld, während die weitere Elektrode dieses Feld aufnimmt oder empfängt und dann ebenfalls ausstrahlt. Die Sendeelektrode ist niederohmig, vorzugsweise sehr niederohmig (z.B. kleiner gleich 200 Ohm) mit einer Steuereinheit verbunden, während die weitere Elektrode hochohmig mit der Steuereinheit verbunden ist und nicht von der Steuereinheit mit einem Signal zur Erzeugung des elektrischen Felds gespeist wird. Vielmehr wird an der weiteren Elektrode ein Signal hochohmig abgegriffen, das ein Indikator für eine Veränderung der Kapazität zwischen der weiteren Elektrode und einem Bezugspotenzial ist. Der wesentliche Unterschied zum Stand der Technik besteht darin, dass das Signal der Sendeelektrode nicht wie im Stand der Technik von der Sensorelektrode abgegriffen, z. B. mit einem "hochohmigen" Eingang eines Impedanzwandlers, und dann "niederohmig" an eine Schirmelektrode / Guardelektrode gegeben wird. Stattdessen wird die Sendeelektrode mit einem eigenständigen, von der Sensorelektrode, die hier als weitere Elektrode bezeichnet ist, vollständig unabhängigen Signal gespeist.

Das heißt: wenn aus irgendwelchen Gründen das "Signal" an der Sensorelektrode, sich ändert, z.B. in Folge einer Benetzung verringert wird, wird das Signal an der Sendeelektrode nicht wie im Stand der Technik mit verringert, sondern wird erfindungsgemäß sogar vergrößert.

Im Stand der Technik würde ein Wasserbelag z.B. die Kapazität zwischen Sensorfläche und einer Bezugsmasse leicht erhöhen und somit die Spannung an der Sensorfläche etwas verkleinern. Damit würde die nachgeführte "Schirmelektrode" auch eine kleinere Spannung bekommen und das Wasser hat somit wieder einen größeren Einfluss. Somit ist die Wirkung der "Schirmelektrode" auf den Feuchte-Einfluss nur gering. Die Hauptwirkung einer derartigen "Schirmelektrode" dürfte in der Reduzierung der Kapazität zwischen Sensorelektrode und entsprechenden Masseflächen bestehen.

Verfahrensgemäß bleibt bei einer irgendwie gearteten Änderung der Spannung an der Sensorelektrode die Sendeelektrode unbeeinflusst. Bei einer theoretischen "Abnahme" der Spannung an der Sensorelektrode durch Wassereinfluss zwischen der Sensorelektrode und umgebender Nassfläche wird der Feuchtefilm durch die dazwischen liegende Sendelektrode direkt oder kapazitiv weiterhin mit der ursprünglichen, nicht veränderten Signalspannung beaufschlagt. Dies führt dazu, dass das Spannungssignal an der Sendeelektrode höher ist als an der Sensorelektrode. Dies ist somit genau das Gegenteil der Lösungen im Stand der Technik.

Damit spielt ein Belag oder eine Benetzung der Vorrichtung keine Rolle mehr und kann sich auf die Erfassung von Änderungen im Sensorumfeld nicht auswirken. Dabei wird die Sendeelektrode zwischen der weiteren Elektrode und einem Bezugspotenzial bzw. einem auf dem Bezugspotenzial liegenden Element wie z.B. einem metallischen Einbauort angeordnet. Dies führt dazu, dass die Wirkung der Sendeelektrode auf einen Belag oder eine Benetzung größer ist als die Wirkung des Belags oder der Benetzung auf eine Kapazität zwischen der Empfängerelektrode (der weiteren Elektrode) und dem Bezugspotenzial. Dadurch wirkt auch ein eventueller Belag noch als ein das elektrische Feld aussendendes Element, selbst wenn eine Verbindung des Belags zum Bezugspotenzial erfolgt.

Eine erste Sendeelektrode wird mit einem Sensorsignal wie z.B. 100 KHz Sinus oder Rechteck beaufschlagt und durch die kapazitive Wirkung zwischen der Sendeelektrode und der weiteren Elektrode wird die weitere Elektrode im Wesentlichen auf demselben elektrischen Potenzial und dennoch unabhängig mitgeführt, also nicht dadurch, dass wie im Stand der Technik eine Schirmelektrode der Spannung der Sendeelektrode nachgeführt wird. Sowohl die Sendeelektrode als auch die weitere Elektrode senden damit ein Sensorsignal aus. Die weitere Elektrode wird nicht von der Steuereinheit mit einem Signal zur Erzeugung des elektrischen Felds gespeist. Zur Bestimmung der Kapazität der weiteren Elektrode gegen Masse wird die Abschwächung dieses Signals an der weiteren Elektrode bestimmt. Bei niederohmiger Anbindung der ersten Sendeelektrode an die Treiberstufe der Treiber-/ Auswerteeinheit und Einkopplung des magnetischen Felds in mögliche Beläge oder Benetzung sowie bei hochohmiger Anbindung der weiteren Elektrode an die Auswertung der Treiber-/ Auswerteeinheit lassen sich Störeinflüsse durch Benetzung oder Verschmutzung verhindern.

Um sicher zu stellen, dass die Sendeelektrode eine größere elektrische Wirkung auf die Benetzung oder Verschmutzung ausübt als die Benetzung oder Verschmutzung zwischen der weiteren Elektrode und dem Bezugspotenzial, wird vorzugsweise die Sendeelektrode, gleichgültig ob sie als Ring, Rohr oder einzelne Elektrode an gemeinsamen oder benachbarten Flächen angeordnet ist, gegenüber der jeweiligen zugeordneten Oberfläche so angeordnet, dass ihr Abstand zur Oberfläche geringer ist als der Abstand der weiteren Elektrode zur nächstliegenden Oberfläche und/oder dass ihre Größe größer als die Größe der weiteren Elektrode ist.

Vorzugsweise ist sicher zu stellen, dass die das elektrische Feld erzeugende Sendeelektrode die weitere Elektrode zumindest teilweise umgibt, vorzugsweise zumindest in Richtung auf das Bezugspotenzial. Insofern kann ein kapazitiver Sensor z.B. auch im Rahmen einer Stoßstange als kapazitiver Annäherungssensor verwendet werden, sofern die weitere Elektrode gegen das Bezugspotenzial z.B. dem Fahrzeugchassis von der Sendeelektrode weitestgehend umgeben ist.

Vorzugsweise ist die Sendeelektrode bei Vorhandensein eines Belags so ausgebildet, dass dort, wo am Sensor ein Belag oder eine Benetzung auftritt, die Sendeelektrode das elektrische Feld in den Belag oder die Benetzung so einkoppelt, dass der Belag oder die Benetzung selbst wieder zu einer sendenden "Elektrode" wird. Dadurch ist ein Einfluss eines Belags oder einer Verschmutzung auf die weitere Elektrode ausgeschlossen.

Weitere Merkmale und Vorteile der Erfindung ergeben sich aus den Ansprüchen und der nachfolgenden Beschreibung bevorzugter Ausführungsformen in Zusammenhang mit den Zeichnungen. Einzelmerkmale der unterschiedlichen in den Zeichnungen dargestellten Ausführungsformen können dabei in beliebiger Weise kombiniert werden, ohne den Rahmen der vorliegenden Erfindung zu überschreiten.

### Kurzbeschreibung der Figuren

Im Folgenden wird die Erfindung anhand von in den beigefügten Figuren dargestellten Ausführungsbeispielen näher erläutert. Es zeigen:
- Fig.1: eine Schnittansicht durch eine Vorrichtung mit einem Sensor mit zylinderförmigen Sensorkopf,
- Fig.2: eine Schnittdarstellung durch eine Vorrichtung in einer weiteren Ausführungsform mit einem flächigen Sensorkopf,
- Fig.3: eine Vorderansicht einer weiteren Sensorform, wie sie z.B. im Bereich einer Stoßstange eines Fahrzeugs verwendet werden kann,
- Fig. 4: einen Schnitt durch einen Sensor gemäß Fig. 2 mit angedeuteten Feldlinien,
- Fig. 5: eine Darstellung gemäß Fig. 4 bei Vorliegen eines Belags oder einer Benetzung,
- Fig. 6: eine Darstellung gemäß Fig. 5 bei Annäherung eines Objekts,
- Fig. 7: ein Blockschaltbild einer erfindungsgemäßen Vorrichtung zur Erfassung von kapazitiven Änderungen, und
- Fig.8: ein Blockschaltbild gemäß Fig. 7, wobei die Summationswiderstände durch Impedanzwandler ersetzt sind.

### Ausführliche Beschreibung bevorzugter Ausführungsbeispiele

Die Erfindung wird jetzt beispielhaft unter bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen. Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

Im Rahmen dieser Anmeldung werden die Begriffe "niederohmig" und "hochohmig" verwendet. Eine niederohmige Verbindung liegt vor, wenn die Sendeelektrode 15 direkt oder über einen Widerstand oder ein Widerstandsnetzwerk an einem Ausgang angeschlossen ist und die auftretende Kapazität gegen Masse zum Beispiel 80 pF beträgt, so dass das Signal an der Sendeelektrode so wenig "verschliffen" wird, dass sich keine Auswirkungen zeigen. Eine Objektannäherung mit einer Änderung von z.B. 1 pF ruft dann keine Wirkung im Ausgangssignal hervor. Hochohmig bedeutet, dass ein Signal, das über diesen Widerstand oder dieses Widerstandsnetzwerk geschickt wird, eine Veränderung zum Beispiel bei der Objektannäherung erfährt, die eindeutig erfasst werden kann und im Messsignal eine messbare Veränderung bewirkt. Im konkreten Fall liegt nach dieser Definition eine niederohmige Verbindung im Bereich von z.B. <200 Ohm vor, während eine hochohmige Verbindung bei einem Widerstand im Bereich von z.B. > 50 kOhm vorliegt. Zwischen diesen Werten sind von beiden beschriebenen Szenarien Einflüsse festzustellen. Die hier genannten Werte sind abhängig von der verwendeten Messfrequenz. Wesentlich ist, dass ohne Objektannäherung die Spannung an der weiteren Elektrode 13 auf Grund der Kapazität zwischen Sendelektrode 15 und weiterer Elektrode 13 nahezu gleich groß ist wie die Spannung der Sendeelektrode 15. Dies kann durch Abnahme der Spannung der weiteren Elektrode 13 mittels eines hochohmigen Feldeffekttransistors oder einer hochohmigen Einkoppelung mittels eines hochohmigen Widerstandes in einen relativ niederohmigen Verstärkereingang erfolgen.

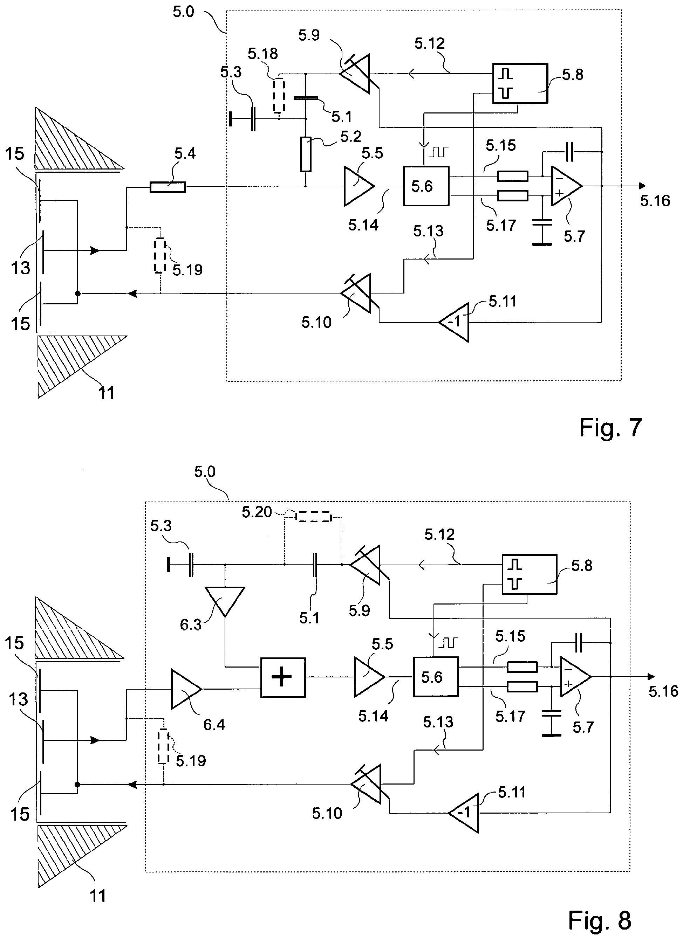

Sollte die rein kapazitive Kopplung zwischen Sendeelektrode 15 und weiterer Elektrode 13 zu gering sein und sich daher nicht die gleiche Spannung an der weiteren Elektrode wie an der Sendelektrode einstellen, kann hilfsweise ein hochohmiger Widerstand 5.18, 5.19, 5.20 und/oder eine weitere Kapazität - wie in den Fig. 7 und 8 gestrichelt angedeutet - zwischen Sendelektrode 15 und weiterer Elektrode 13 geschaltet werden.

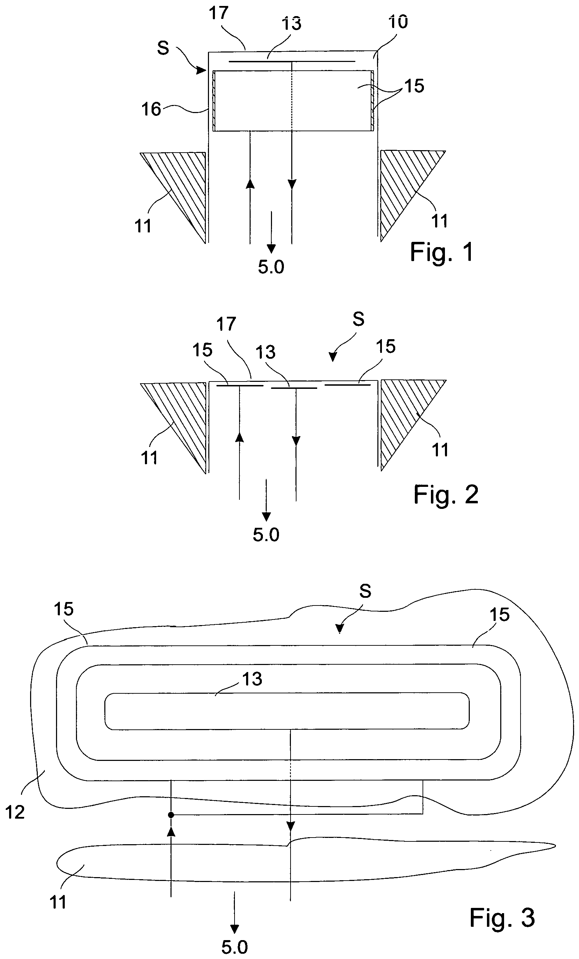

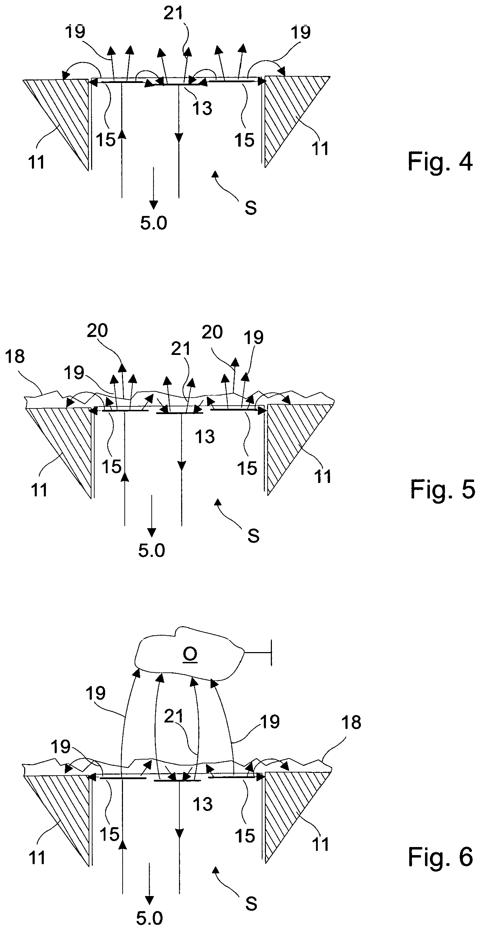

Die Figuren 1 bis 3 zeigen Vorrichtungen zur kapazitiven Messung von Änderungen in einem sensoraktiven Bereich eines Sensors S. Der Sensor weist wenigstens zwei Elektroden 13, 15 auf, die in geeigneter Weise an eine Treiber-/ Auswerteeinheit 5.0 gekoppelt sind, die in den Figuren 6 und 7 dargestellt ist. Es können insofern auch mehrere Elektroden sowohl als Sendeelektroden 15 oder auch als kapazitiv an die Sendeelektrode gekoppelte weitere Elektroden 13 vorgesehen sein. Fig. 2 zeigt eine ringförmige Sendeelektrode 15, die alternativ auch durch mehrere Sendeelektroden gebildet sein könnte.

Die erste Elektrode ist eine das elektrische Feld erzeugende vorzugsweise rohr- oder ringförmige Sendeelektrode 15. Die Treiber-/ Auswerteeinheit 5.0 dient zur Auswertung der vom Sensor S gemessenen Änderungen. Dazu steht der Sensor S elektrisch mit der Treiber-/ Auswerteeinheit 5.0 in Verbindung, in der eine Änderung des elektrischen Felds und somit eine Änderung der Kapazitäten insbesondere zwischen den Elektroden 13 und einem Bezugspotenzial, wie z.B. Masse erfasst und ausgewertet wird. Sendeelektrode 15 und weitere Elektrode 13 befinden sich bei einer Messung der Kapazität gegen das Bezugspotenzial im Wesentlichen auf demselben elektrischen Potenzial, solange keine Änderung im Sensorumfeld wie z.B. durch Annäherung eines Objekts O erfolgt, wobei die Sendeelektrode 15 im Sensor S mit einem Wechselstromsignal beaufschlagt wird. Die weitere Elektrode 13 ist kapazitiv an die Sendeelektrode 15 gekoppelt und wird insofern kapazitiv mitgeführt, d.h. durch kapazitive Kopplung wird die Spannung von der Sendeelektrode auf die weitere Elektrode 13, die eigentliche Sensorelektrode, übertragen, im Gegensatz zum Stand der Technik sind die beiden aber nicht durch eine elektrische Leitungsverbindung zwischen Sendeelektrode 15 und weitere Elektrode 13 wie bei einer Abschirmelektrode verbunden.

Der wesentliche Unterschied zum Stand der Technik besteht darin, dass das Signal der Sendeelektrode 15 nicht wie im Stand der Technik von der weiteren Elektrode 13 als Sensorelektrode abgegriffen, z. B. mit einem "hochohmigen" Eingang eines Impedanzwandlers, und dann "niederohmig" an eine Schirmelektrode / Guardelektrode gegeben wird. Stattdessen wird die Sendeelektrode 15 mit einem eigenständigen, von der weiteren Elektrode 13 unabhängigen Signal gespeist. Die Sendeelektrode 15 ist zwischen der weiteren Elektrode 13 und einem Bezugspotenzial bzw. einem auf dem Bezugspotenzial liegenden Element 11 angeordnet. Die Treiber-/ Auswerteeinheit 5.0 besitzt insofern Mittel zum Anlegen eines ersten Potenzials an die Sendeelektrode 15 und Mittel zum Messen einer Kapazität zwischen der weiteren Elektrode 13 und einem auf dem Bezugspotenzial liegenden Element 11.

Die wenigstens eine Sendeelektrode 15 und die weitere Elektrode 13 können in einem Kunststoffmaterial eingebettet oder auf beliebige andere Weise zueinander angeordnet sein. Entsprechende Herstellungsverfahren sind dem Fachmann bekannt. Die Sendeelektrode 15 wird mit einem Wechselstromsignal gespeist und aufgrund der Kapazität zwischen den beiden Elektroden 13, 15 folgt die weitere Elektrode 13 dem Signalverlauf an der ersten Sendeelektrode 15. Die weitere Elektrode 13 strahlt somit das Wechselstromsignal ins Sensorumfeld ab. Damit verlaufen die elektrischen Feldlinien 19, 21 ohne ein Objekt gemäß Fig. 4 ins Umfeld. Die kapazitive Kopplung kann zwischen der Sendeelektrode 15 und der weiteren Elektrode 13 auch bzw. ergänzend über eine extern zwischengeschaltete Kapazität erfolgen.

Das heißt: wenn aus irgendwelchen Gründen das "Signal" an der weiteren Elektrode 13 sich ändert, z.B. in Folge einer Benetzung verringert wird, wird das Signal an der Sendeelektrode 15 nicht wie im Stand der Technik mit verringert, sondern bleibt unbeeinflusst oder wird gemäß dem Ausführungsbeispiel der Fig. 7, 8 sogar vergrößert.

Im Stand der Technik würde ein Wasserbelag z.B. die Kapazität zwischen Sensorfläche und einer Bezugsmasse leicht erhöhen und somit die Spannung an der Sensorfläche etwas verkleinern. Damit würde die nachgeführte "Schirmelektrode" auch eine kleinere Spannung bekommen und das Wasser hat somit wieder einen größeren Einfluss. Somit ist die Wirkung "Schirmelektrode" auf den Feuchte-Einfluss nur gering.

Im Verfahren bleibt bei einer irgendwie gearteten Änderung der Spannung an der der Sensorelektrode entsprechenden weiteren Elektrode 13 die Sendeelektrode 15 weitestgehend unbeeinflusst. Bei einer theoretischen "Abnahme" der Spannung an der weiteren Elektrode 13 durch Wassereinfluss zwischen der weiteren Elektrode und umgebender Nassfläche wird der Feuchtefilm durch die dazwischen liegende Sendelektrode 15 direkt oder kapazitiv weiterhin mit der ursprünglichen, nicht veränderten Signalspannung beaufschlagt. Dies führt dazu, dass das Spannungssignal an der Sendeelektrode 15 höher ist als an der weiteren Elektrode 13. Im Ausführungsbeispiel der Fig. 7, 8 wird sogar bei "Abnahme" der Spannung an der weiteren Elektrode 13 die Spannung an der Sendeelektrode 15 erhöht, so dass die "Abnahme" der Spannung an der weiteren Elektrode wieder ausgeglichen wird. Dies ist somit genau das Gegenteil der Lösungen im Stand der Technik.

Der oben erwähnte "theoretische" Einfluss von Wasser ist bei entsprechender Einkoppelung der Feldlinien der Sendelektrode 15 in den umgebenden Wasserfilm nicht messbar. Nur eine Annäherung eines leitfähigen Körpers von Außen an die Messvorrichtung wird detektiert.

Im Stand der Technik liegt durch das Nachführen der Schirmelektrode auf das Potential der Sendeelektrode eine Mitkopplung vor, wogegen erfindungsgemäß eine Gegenkopplung gegeben ist.

Da die weitere Elektrode 13 vorzugsweise rein kapazitiv an die Sendeelektrode 15 angekoppelt ist und somit bei hochohmiger Abnahme des Signals auf gleichem Potenzial mitgeführt wird, haben Störeinflüsse durch Feuchtigkeit, Benetzung oder Belag 18 gemäß Fig. 5 keinen Einfluss. Solche Schichten aus elektrisch leitfähiger Flüssigkeit, beispielsweise Wasser, werden nämlich in ähnlicher Weise wie die weitere Elektrode 13 auf dem elektrischen Potenzial der beiden Elektroden 13, 15 gehalten und führen damit nicht zu einer Veränderung des von der weiteren Elektrode 13 ausgehenden Feldlinienbildes. Die Benetzung sendet vielmehr selbst gemäß Fig. 5 elektrische Feldlinien 20 aus.

In Fig. 6 befindet sich ein Objekt O im sensoraktiven Bereich. Zur Verdeutlichung sind dabei die Feldlinien 20 weggelassen, die auch dort von der Benetzung 18 ausgehen. Durch das Objekt O kommt es gemäß Fig. 6 zu einer Veränderung im sensoraktiven Bereich, da auch die weitere Elektrode 13 verstärkt Feldlinien 21 zum Objekt ausbildet. Dadurch kommt es zu einem Spannungsabfall an der weiteren Elektrode 13, der durch die Treiber-/ Auswerteeinheit 5.0 wie unten erläutert erfasst wird.

Der Sensor S kann beispielsweise gemäß den Figuren 1 bis 3 in einer dort dargestellten Ausgestaltung aufgebaut sein. Der Abstand der Elektroden 15 zur Außenfläche des Sensors S ist vorzugsweise verhältnismäßig gering, um eine vergleichsweise große Kapazität zu erhalten. Vorzugsweise ist die Sendeelektrode 15 so angeordnet, dass ihr Abstand zur jeweils nächstliegenden Oberfläche 16 in Fig. 1 bzw. 17 in Fig. 2 geringer ist als der Abstand der weiteren Elektrode 13 zur nächstliegenden Oberfläche 17. Analog kann auch die Größe der Sendeelektrode größer als die Größe der weiteren Elektrode sein. Auf diese Weise ist eine Kapazität zwischen der weiteren Elektrode 13 und der Außenfläche des Sensors S kleiner als die Kapazität zwischen der Sendeelektrode und der Außenfläche des Sensors, so dass eine eventuelle Benetzung oder Verschmutzung 18 der Außenfläche eher durch die Sendeelektrode als durch die weitere Elektrode beeinflusst wird. Dazu wird die Sendeelektrode niederohmig angesteuert. Der Einfluss der Benetzung auf das von der Sendeelektrode erzeugte elektrische Feld bleibt dadurch gering. Grundsätzlich sind die Sendeelektroden so aufgebaut, dass sie dort, wo ein Belag oder eine Benetzung 18 auftritt, noch ein elektrisches Feld aussenden und in den Belag oder die Benetzung 18 einleiten können.

Die Sendelektrode 15 kann gemäß Fig. 1 ring- oder rohrförmig ausgebildet sein, es ist jedoch ebenso möglich, sie gemäß Fig. 2 scheibenförmig auszubilden. Ebenso können aber auch zwei oder mehrere miteinander elektrisch verbundene Sendeelektroden vorgesehen sein. Gemäß Fig. 1 ist die Vorrichtung in einem zylinderförmigen Gehäuse 10 angeordnet, an dessen vorderen Ende die ringförmige Sendeelektrode 15 an den Zylinderwandungen angeordnet ist, während die weitere Elektrode 13 stirnseitig angeordnet ist. Die weitere Elektrode 13 kann sowohl innerhalb des Rings als auch stirnseitig vor dem Ring angeordnet sein. Es ist ebenso denkbar, dass die Sendeelektrode die weitere Elektrode 13 nach hinten abdeckt, um sie dadurch gegenüber Einflüssen nach hinten, also in Fig. 1 nach unten abzudecken.

Bei einer Anordnung gemäß Fig. 2 können die wenigstens eine Sendeelektrode 15 und die weitere Elektrode 13 auch etwa in einer Ebene vorzugsweise parallel zu einer gemeinsamen Oberfläche 17 angeordnet sein.

Die Ansicht gemäß Fig. 3 könnte die Frontalansicht auf eine Stoßstange eines Fahrzeugs sein, wobei die Stoßstange z.B. ein Kunststoffteil 12 ist, auf dem die beiden Elektroden 13, 15 angeordnet sind. Läuft Wasser in der Blattebene über die Stoßstange hat dies aus den besagten Gründen keinen Einfluss auf die Kapazität zwischen der weiteren Elektrode 13 und einem auf einem Bezugspotential befindlichen Element 11 wie dem Fahrzeugchassis.

Bei allen Ausführungsformen gilt allerdings vom Grundsatz her, dass dort, wo keine unmittelbare Nähe eines Bezugspotenzials vorliegt, auch nicht unbedingt eine Sendeelektrode angeordnet sein muss, so dass die Sendeelektrode 15 die weitere Elektrode 13 nur teilweise umgeben kann.

Beispielhafte Schaltbilder, für die Treiber-/ Auswerteeinheit 5.0 sind in den Figuren 7 und 8 dargestellt, die die Wirkungsweise der Erfindung bzw. der Treiber-/ Auswerteeinheit 5.0 verdeutlichen sollen. Als Sensor wird dabei die Anordnung gemäß Fig. 2 gewählt, die alternativen Anordnungen gemäß den Figuren 1 und 3 können jedoch ebenfalls eingesetzt werden wie auch weitere Ausgestaltungen für den Fachmann denkbar sind. An der Funktionsweise der Erfindung und speziell an der Funktionsweise der Treiber-/ Auswerteeinheit 5.0 ändert dies nichts. Im Bezug auf die Figuren 7 und 8 werden im Zusammenhang mit Fig. 8 lediglich die von der Treiber-/ Auswerteeinheit 5.0 der Fig. 7 verschiedenen Elemente detailliert erläutert. Im Übrigen sind Elemente, die mit dem gleichen Bezugszeichen versehen sind, identisch oder zumindest funktionell gleich.

In der Treiber-/ Auswerteeinheit 5.0 liefert ein Taktgenerator 5.8 ein erstes Taktsignal 5.13 an einen ersten Amplitudenregler 5.10 und ein zweites, invertiertes Taktsignal 5.12 an einen zweiten Amplitudenregler 5.9. Der niederohmige Ausgang des ersten Amplitudenreglers 5.10 und damit der Ausgang der Treiber-/ Auswerteeinheit 5.0 ist an die Sendeelektrode 15 angeschlossen. Diese überträgt aufgrund kapazitiver Effekte das erste Taktsignal 5.13 auf die weitere Elektrode 13. Eine elektrische Leitungsverbindung zwischen Sendeelektrode 15 und weiterer Elektrode 13 besteht vorzugsweise nicht. Über den hochohmigen Summationswiderstand 5.4 wird das Signal der weiteren Elektrode 13 auf den Eingang des Wechselspannungsverstärkers 5.5 gegeben. Das zweite, zum ersten Taktsignal 5.13 invertierte Taktsignal 5.12 wird über den zweiten Amplitudenregler 5.9 auf die Referenzreihenkapazität 5.1 und über einen zweiten, hochohmigen Summationswiderstand 5.2 auf den Eingang des Wechselspannungsverstärkers 5.5 gegeben. Der Eingang des Wechselspannungsverstärkers 5.5 ist auch der Eingang der Treiber-/ Auswerteeinheit 5.0. Die Referenzreihenkapazität 5.1 sollte in etwa die gleiche Größe wie die Kapazität der Elektroden 15 und 13 zueinander aufweisen. Eine auftretende Kapazität der weiteren Elektrode 13 gegenüber der Umgebung kann durch den Parallelkondensator 5.3 ausgeglichen werden. Die Summationswiderstände 5.2 und 5.4 sollten vorzugsweise hochohmig sein und gleiche Werte aufweisen.

Bei entsprechender Amplitudenregelung heben sich die zuvor summierten Taktsignale 5.12 und 5.13 am Eingang des vorzugsweise als Wechselspannungsverstärkers ausgebildeten Verstärkers 5.5 auf. Da der Verstärker 5.5. am Eingang im Idealfall nach dem gegenseitigen Auslöschen der Taktsignale lediglich Rauschen sieht, kann er sehr hoch verstärken, bzw. als hochverstärkender Begrenzerverstärker ausgeführt werden.

Das Ausgangssignal 5.14 des Verstärkers 5.5 wird dem Synchrondemodulator 5.6 zugeführt. Die den beiden Taktsignalen 5.12 und 5.13 zuordenbaren Ausgangssignale des Synchrondemodulators 5.6 werden vom integrierenden Komparator 5.7 auf Amplitudenunterschiede untersucht. Der Komparator 5.7 kann als hochverstärkende Vergleicherschaltung ausgeführt sein. Jede noch so kleine Abweichung der Eingangsspannung 5.15 und 5.17 führt zu einer entsprechenden Abweichung des Regelwertes 5.16 vom momentanen Wert. Die Amplitudenregler 5.9 und 5.10 werden mittels Invertierstufe 5.11 gegeneinander mit dem Regelwert 5.16 invertiert angesteuert. Steigt die Ausgangsamplitude eines Amplitudenreglers an, so fällt sie im anderen entsprechend ab. Somit wird das Eingangssignal des Wechselspannungsverstärkers 5.5 ständig auf Null gehalten, d.h., es sind keinerlei taktsynchronen Signalanteile enthalten.

Ändert sich beispielsweise durch ein Objekt O die Kapazität der weiteren Elektrode 13 gegenüber dem Bezugspotenzial, wirkt diese zusätzliche Kapazität zusammen mit der Kapazität zwischen den Elektroden 15 und 13 ähnlich einem kapazitiven Spannungsteiler und die Spannung an der weiteren Elektrode 13 nimmt entsprechend ab. Diese Abnahme führt am Eingang des Verstärkers 5.5 zur unvollständigen Auslöschung der Taktsignale 5.12 und 5.13. Nach der Synchrondemodulation im Synchrondemodulator 5.6 und Auswertung der Abweichung der Unterschiede in den separierten Signalanteilen der Eingangsspannungen 5.15 und 5.17 führt dies zu einer Abweichung des Regelwerts 5.16. Dieser Regelwert 5.16 kann dann zur Anzeige der im sensoraktiven Bereich des Sensors S erfolgten Änderung herangezogen werden. Die Abweichung im Regelwert 5.16 wird so lange gegenüber einem vorherigen Wert ansteigen bzw. abfallen, bis sich am Eingang des Wechselspannungsverstärkers 5.5 das Taktsignal 5.13 und das invertierte Taktsignal 5.12 wieder vollständig aufheben.

Im übrigen können die in Figur 7 gezeigten Summationswiderstände 5.2 bzw. 5.4 auch durch Kondensatoren bzw. Reihenschaltungen aus Widerstand und Kondensator ersetzt werden. Vorteilhaft können die Summationswiderstände 5.2 und 5.4 gemäß Figur 6 auch durch Impedanzwandler 6.3 bzw. 6.4 mit hochohmigem Eingang ausgeführt werden, wie dies in Fig. 8 dargestellt ist. Durch die aktive Beschaltung wird das Nutzsignal an der weiteren Elektrode 13 nicht belastet.

Die erfindungsgemäße Vorrichtung zur kapazitiven Messung von Änderungen in einem sensoraktiven Bereich kann auf verschiedensten Gebieten eingesetzt werden. Beispielsweise sind im Bereich industrieller Anwendungen die Erfassung der Annäherung von Objekten oder Medien möglich. Weitere Anwendungen sind in der Anlagentechnik sowie in der Robotik denkbar. Viele Anwendungsmöglichkeiten ergeben sich auch im Automobil- und Nutzfahrzeugbereich, beispielsweise zur Erfassung von Bewegungen am, im oder um das Fahrzeug. Grundsätzlich kann die Vorrichtung überall eingesetzt werden, wo es auf die Erfassung von Änderungen in einem elektrischen Feld ankommt, aber ein eventueller Balg nicht gesehen werden soll.

Es versteht sich von selbst, dass diese Beschreibung verschiedensten Modifikationen, Änderungen und Anpassungen unterworfen werden kann, die sich im Bereich von Äquivalenten zu den anhängenden Ansprüchen bewegen.

### Bezugszeichenliste

- 5.0: Treiber-/ Auswerteeinheit
- 5.1: Referenz Reihenkapazität
- 5.2: hochohmiger Summationswiderstand
- 5.3: Parallelkondensator
- 5.4: hochohmiger Summationswiderstand
- 5.5: Wechselspannungsverstärker
- 5.6: Synchrondemodulator
- 5.7: integrierender Komparator
- 5.8: Taktgenerator
- 5.9: Amplitudenregler
- 5.10: Amplitudenregler
- 5.11: Invertierstufe
- 5.12: invertiertes Taktsignal
- 5.13: erstes Taktsignal
- 5.14: Ausgangssignal
- 5.15: Eingangsspannung
- 5.16: Regelwert
- 5.17: Eingangsspannung
- 5.18, 5.19, 5.20: Widerstand
- 6.3, 6.4: Impedanzwandler
- 10: Gehäuse
- 11: Element auf Bezugspotenzial
- 12: Kunststoffteil
- 13: weitere Elektrode
- 15: Sendeelektrode
- 16, 17: Oberfläche
- 18: Belag oder Benetzung
- 19, 20, 21: Feldlinien
- O: Objekt
- S: Sensor

## Patentansprüche

1. Vorrichtung zur kapazitiven Messung von Änderungen in einem sensoraktiven Bereich eines Sensors (S) unter Erzeugung eines elektrischen Feldes, wobei der Sensor wenigstens zwei Elektroden (13, 15) aufweist, von denen wenigstens eine erste Elektrode eine das elektrische Feld erzeugende Sendeelektrode (15) ist, sowie mit einer Treiber-/ Auswerteeinheit (5.0) zur Auswertung der vom Sensor gemessenen Änderungen, wobei die Sendeelektrode (15) an die weitere Elektrode (13) gekoppelt ist und zwischen der weiteren Elektrode (13) und einem auf einem Bezugspotenzial liegenden Element (11) angeordnet ist und im Betrieb mittels der Treiber-/ Auswerteeinheit (5.0) ein elektrisches Feld erzeugt, wobei ein Ausgang der Treiber-/ Auswerteeinheit (5.0) mit der Sendeelektrode (15) und ein Eingang der Treiber-/ Auswerteeinheit (5.0) mit der weiteren Elektrode (13) gekoppelt ist, wobei die Sendeelektrode (15) mit einem eigenständigen Signal gespeist wird, und wobei sich aufgrund des von der Sendeelektrode (15) erzeugten elektrischen Feldes zwischen der Sendeelektrode (15) und der weiteren Elektrode (13) ein elektrisches Feld zwischen der weiteren Elektrode (13) und dem Bezugspotenzial ausbildet, wobei mittels der Treiber-/ Auswerteeinheit (5.0) eine Änderung der Kapazität zwischen der weiteren Elektrode (13) und dem Bezugspotenzial detektiert wird und wobei der Ausgang der Treiber-/ Auswerteeinheit (5.0) ein niederohmiger Ausgang der Treiber-/ Auswerteeinheit (5.0) ist und dieser an die Sendeelektrode (15) angeschlossen ist und wobei eine Signalspannung der weiteren Elektrode (13) hochohmig auf den Eingang der Treiber-/ Auswerteeinheit (5.0) gegeben wird,
die Vorrichtung ist **dadurch gekennzeichnet, dass** die Treiber-/ Auswerteeinheit (5.0) derart ausgebildet ist, dass bei einer Verringerung der Signalspannung an der weiteren Elektrode (13) das eigenständige Signal der Sendeelektrode (15) erhöht wird, wobei die wenigstens eine Sendeelektrode (15) rohr- oder ringförmig ist.

2. Vorrichtung nach Anspruch 1, wobei die weitere Elektrode (13) rein kapazitiv an die Sendeelektrode (15) gekoppelt ist.

3. Vorrichtung nach einem der vorhergehenden Ansprüche, wobei die Treiber-/ Auswerteeinheit (5.0) Mittel zum Anlegen eines ersten Potenzials an die Sendeelektrode (15) und Mittel zum Messen einer Kapazität zwischen der weiteren Elektrode (13) und einem auf dem Bezugspotenzial liegenden Element (11) aufweist.

4. Vorrichtung nach einem der vorhergehenden Ansprüche, die dazu ausgebildet ist, dass die wenigstens eine Sendeelektrode (15) mittels der Treiber-/ Auswerteeinheit (5.0) mit einem Wechselstromsignal beaufschlagt wird.

5. Vorrichtung nach einem der vorhergehenden Ansprüche, wobei die Sendeelektrode (15) und die weitere Elektrode (13) hinter wenigstens einer nach außen weisenden Oberfläche (16, 17) des Sensors (S) angeordnet sind, wobei der Abstand der Sendeelektrode (15) zur Oberfläche (16, 17) geringer ist als der Abstand der weiteren Elektrode (13) zur Oberfläche (17).

6. Vorrichtung nach einem der vorhergehenden Ansprüche, wobei die Sendeelektrode (15) ringförmig ausgebildet ist.

7. Vorrichtung nach Anspruch 6, wobei der Sensor (S) in einem zylinderförmigen Gehäuse (10) angeordnet ist, an dessen vorderen Ende die ringförmige Sendeelektrode (15) an Zylinderwandungen angeordnet ist, während die weitere Elektrode (13) stirnseitig angeordnet ist.

8. Vorrichtung nach einem der Ansprüche 1 bis 5, wobei die wenigstens eine Sendeelektrode (15) und die weitere Elektrode (13) etwa in einer Ebene vorzugsweise parallel zu einer gemeinsamen Oberfläche (17) angeordnet sind.

9. Vorrichtung nach einem der vorhergehenden Ansprüche, wobei die Sendeelektrode (15) die weitere Elektrode (13) wenigstens teilweise umgibt.

10. Vorrichtung nach einem der vorhergehenden Ansprüche, die dazu ausgebildet ist, dass die weitere Elektrode (13) kapazitiv an die Sendeelektrode (15) angekoppelt ist und bei hochohmiger Abnahme des Signals auf gleichem Potenzial liegt, wobei die Sendeelektrode (15) bei Vorhandensein eines Belags oder einer Benetzung auf dem Gehäuse (10) des Sensors (18) so ausgebildet ist, dass dort, wo am Sensor (S) ein Belag oder eine Benetzung (18) auftritt, die Sendeelektrode (15) das elektrische Feld in den Belag oder die Benetzung so einkoppelt, dass der Belag oder die Benetzung selbst wieder zu einer sendenden "Elektrode" wird.

## Claims

1. Apparatus for the capacitive measurement of changes in a sensor-active region of a sensor (S) utilising the production of an electrical field, wherein the sensor comprises at least two electrodes (13, 15) of which at least a first electrode is a transmitting electrode (15) producing the electrical field, and a driver / evaluation unit (5.0) for the evaluation of the changes measured by the sensor, wherein the transmitting electrode (15) is coupled to the further electrode (13) and is arranged between the further electrode (13) and an element (11) being at a reference potential and produces an electrical field by means of the driver / evaluation unit (5 0) when in operation,
wherein an output of the driver / evaluation unit (5.0) is coupled to the transmitting electrode (15) and an input of the driver / evaluation unit (5.0) is coupled to the further electrode (13), wherein the transmitting electrode (15) is fed with an independent signal, and wherein an electrical field is formed between the further electrode (13) and the reference potential due to the electrical field between the transmitting electrode (15) and the further electrode (13) that is produced by the transmitting electrode (15), wherein a change of the capacitance between the further electrode (13) and the reference potential is detected by means of the driver / evaluation unit (5.0), and wherein the output of the driver / evaluation unit (5.0) is a low impedance output and is coupled to the transmitting electrode (15) and wherein a signal voltage of the further electrode (13) is applied to the input of the driver / evaluation unit (5.0) in high impedance manner, the apparatus being **characterized in that** the driver / evaluation unit (5.0) is so designed that, when the signal voltage at the further electrode (13) is reduced, the independent signal of the transmitting electrode (15) is increased, wherein the at least one transmitting electrode (15) is tubular or annular.

2. Apparatus according to Claim 1, wherein the further electrode (13) is coupled only capacitively to the transmitting electrode (15).

3. Apparatus according to any of the preceding Claims, wherein the driver / evaluation unit (5.0) comprises means for applying a first potential to the transmitting electrode (15) and means for measuring a capacitance between the further electrode (13) and an element (11) being at the reference potential.

4. Apparatus according to any of the preceding Claims, which is designed that an alternating current signal is applied to the at least one transmitting electrode (15) by means of the driver / evaluation unit (5.0).

5. Apparatus according to any of the preceding Claims, wherein the transmitting electrode (15) and the further electrode (13) are arranged behind at least one outwardly facing surface (16, 17) of the sensor (S), wherein the spacing of the transmitting electrode (15) from the surface (16, 17) is smaller than the spacing of the further electrode (13) from the surface (17).

6. Apparatus according to any of the preceding Claims, wherein the transmitting electrode (15) is annular.

7. Apparatus according to Claim 6, wherein the sensor (S) is arranged in a cylindrical housing (10) at the front end of which the annular transmitting electrode (15) is arranged on cylinder walls, whilst the further electrode (13) is arranged at the front.

8. Apparatus according to any of the Claims 1 to 5, wherein the at least one transmitting electrode (15) and the further electrode (13) are arranged approximately in a plane preferably parallel to a common surface (17).

9. Apparatus according to any of the preceding Claims, wherein the transmitting electrode (15) at least partly surrounds the further electrode (13).

10. Apparatus according to any of the preceding Claims, which is designed that the further electrode (13) is coupled capacitively to the transmitting electrode (15) and is at the same potential wherein the signal is derived in high impedance manner, wherein, in the presence of a coating or a wetting on the housing (10) of the sensor (18), the transmitting electrode (15) is designed in such a manner that, in the region where a coating or a wetting (18) occurs on the sensor (S), the transmitting electrode (15) couples the electrical field into the coating or the wetting in such a way that the coating or the wetting itself becomes a transmitting "electrode".

## Revendications

1. Dispositif pour la mesure capacitive de variations dans un domaine actif de détection d'un détecteur (S) par production d'un champ électrique, dans lequel le détecteur comporte au moins deux électrodes (13, 15), dont au moins une première électrode est une électrode émettrice (15) produisant le champ électrique, ainsi qu'une unité de commande/traitement (5.0) pour le traitement des variations mesurées par le détecteur, dans lequel l'électrode émettrice (15) est couplée à l'autre électrode (13) et est disposée entre l'autre électrode (13) et un élément se trouvant à un potentiel de référence et produit lors du fonctionnement au moyen de l'unité de commande/traitement (5.0) un champ électrique, dans lequel une sortie de l'unité de traitement/commande (5.0) est couplée avec l'électrode émettrice (15) et une entrée de l'unité de commande/traitement (5.0) avec l'autre électrode (13), dans lequel l'électrode émettrice (15) est alimentée avec un signal autonome et dans lequel, en raison du champ électrique produit par l'électrode émettrice (15), il se forme entre l'électrode émettrice (15) et l'autre électrode (13) un champ électrique entre l'autre électrode (13) et le potentiel de référence, dans lequel au moyen de l'unité de commande/traitement (5.0) une variation de la capacité entre l'autre électrode (13) et le potentiel de référence est détectée et dans lequel la sortie de l'unité de traitement/commande (5.0) est une sortie à basse résistance de l'unité de commande/traitement (5.0) et est connectée à l'électrode émettrice (15) et dans lequel une tension de signal est appliquée à l'autre électrode (13) avec une résistance élevée à l'entrée de l'unité de commande/traitement (5.0), ce dispositif étant **caractérisé en ce que** l'unité de commande/traitement (5.0) est réalisée de telle sorte que lors d'une diminution de la tension de signal au niveau de l'autre électrode (13), le signal autonome de l'électrode émettrice (15) est augmenté, la ou les électrodes émettrice(s) (15) étant de forme tubulaire ou annulaire.

2. Dispositif selon la revendication 1, dans lequel l'autre électrode (13) est couplée de manière purement capacitive à l'électrode émettrice (15).

3. Dispositif selon l'une des revendications précédentes, dans lequel l'unité de commande/traitement (5.0) comporte des moyens pour appliquer un premier potentiel à l'électrode émettrice (15) et des moyens pour mesurer une capacité entre l'autre électrode (13) et un élément se trouvant au potentiel de référence (11).

4. Dispositif selon l'une des revendications précédentes, réalisé de telle manière que la ou les électrode(s) émettrice(s) (15) est/sont soumise(s) à un signal de courant alternatif au moyen de l'unité de commande/traitement (5.0).

5. Dispositif selon l'une des revendications précédentes, dans lequel l'électrode émettrice (15) et l'autre électrode (13) sont disposées derrière au moins une surface tournée vers l'extérieur (16, 17) du détecteur (S), la distance entre l'électrode émettrice (15) et la surface (16, 17) étant inférieure à la distance entre l'autre électrode (13) et la surface (17).

6. Dispositif selon l'une des revendications précédentes, dans lequel l'électrode émettrice (15) est réalisée sous forme annulaire.

7. Dispositif selon la revendication 6, dans lequel le détecteur (S) est disposé dans un boîtier cylindrique à l'extrémité avant duquel l'électrode émettrice (15) de forme annulaire est disposée au niveau de parois du cylindre, tandis que l'autre électrode (13) est disposée du côté frontal.

8. Dispositif selon l'une des revendications 1 à 5, dans lequel la ou les électrode(s) émettrice(s) (15) et l'autre électrode (13) sont disposées sensiblement dans un plan, de préférence parallèle à une surface commune (17).

9. Dispositif selon l'une des revendications précédentes, dans lequel l'électrode émettrice (15) entoure au moins partiellement l'autre électrode (13).

10. Dispositif selon l'une des revendications précédentes, réalisé de telle manière que l'autre électrode (13) est couplée de manière capacitive à l'électrode émettrice (15) et se trouve, lors d'une diminution de résistance élevée du signal, au même potentiel, l'électrode émettrice (15) étant réalisée, en cas de présence d'un recouvrement ou d'un mouillage sur le boîtier (10) du détecteur (18), de telle manière qu'à l'endroit du détecteur (S) où a lieu le recouvrement ou le mouillage (18), l'électrode émettrice (15) envoie le champ magnétique dans le recouvrement ou le mouillage de telle manière que le recouvrement ou le mouillage devienne lui-même à nouveau une « électrode » émettrice.
